# EUROPÄISCHE PATENTSCHRIFT

(11) **EP 3 247 558 B1**
(45) Veröffentlichungstag und Bekanntmachung des Hinweises auf die Patenterteilung: **02.06.2021**
(21) Anmeldenummer: 16700818.4
(22) Anmeldetag: 15.01.2016
(51) Int. Cl.: B32B 17/10, B60J 1/00, B60R 16/023, H03K 17/96

(54) **VERBUNDSCHEIBE MIT KAPAZITIVEM SCHALTBEREICH**
LAMINATED GLAZING WITH CAPACITIVE SWITCHING AREA
VITRAGE STRATIFIÉ AVEC ZONE DE COMMUTATION CAPACITIVE

(30) Priorität: 20.01.2015 EP 15151763
(43) Veröffentlichungstag der Anmeldung: 29.11.2017
(73) Patentinhaber: SAINT-GOBAIN GLASS FRANCE, 92400 Courbevoie (FR)
(72) Erfinder: WEBER, Patrick, 52477 Alsdorf (DE); DROSTE, Stefan, 52134 Herzogenrath (DE)
(74) Vertreter: Gebauer, Dieter Edmund
(86) Internationale Anmeldenummer: PCT/EP2016/050789
(87) Internationale Veröffentlichungsnummer: WO 2016/116372

(56) Entgegenhaltungen:
- EP-A- 0 146 198
- WO-A1-2015/086599
- GB-A- 2 090 979
- GB-A- 2 423 808
- US-A1- 2006 275 599
- US-A1- 2010 179 725
- US-B1- 6 654 070

## Beschreibung

Die Erfindung betrifft eine Verbundscheibe mit kapazitivem Schaltbereich, eine Scheibenanordnung, ein Verfahren zur Herstellung der Verbundscheibe und deren Verwendung.

Es ist bekannt, dass Schaltbereiche durch eine Flächenelektrode oder durch eine Anordnung von zwei gekoppelten Elektroden ausgebildet werden können, beispielsweise als kapazitive Schaltbereiche. Nähert sich ein Objekt dem Schaltbereich an, so ändert sich die Kapazität der Flächenelektrode gegen Erde oder die Kapazität des von den zwei gekoppelten Elektroden gebildeten Kondensators. Derartige Schaltbereiche sind beispielsweise aus US 2010/179725 A1, US 6 654 070 B1 und US 2006/275599 A1 bekannt. Insbesondere zeigt US 2010/179725 A1 eine Anordnung, bei der ein kapazitiver Schaltvorgang auf einer Innenseite der Scheibe durch eine elektrisch leitende Schicht unterbunden wird.

Die Kapazitätsänderung wird über eine Schaltungsanordnung oder Sensorelektronik gemessen und bei Überschreiten eines Schwellwerts wird ein Schaltsignal ausgelöst. Schaltungsanordnungen für kapazitive Schalter sind beispielsweise aus DE 20 2006 006 192 U1, EP 0 899 882 A1, US 6,452,514 B1 und EP 1 515 211 A1 bekannt.

Die Aufgabe der vorliegenden Erfindung besteht darin, eine verbesserte Verbundscheibe bereitzustellen, die einen kapazitiven Schaltbereich aufweist, der einfach und kostengünstig in die Verbundscheibe integriert werden kann und der die Durchsicht durch Scheibe nicht oder nur wenig behindert. Mit dem kapazitiven Schaltbereich kann in einfacher Weise ein Berührungssensor gebildet werden.

Die Aufgabe der vorliegenden Erfindung wird erfindungsgemäß durch eine Verbundscheibe mit Schaltbereich gemäß dem unabhängigen Anspruch 1 gelöst. Bevorzugte Ausführungen gehen aus den Unteransprüchen hervor.

Die erfindungsgemäße Verbundscheibe mit kapazitivem Schaltbereich umfasst zumindest die folgenden Merkmale:
- ein Substrat,
- mindestens eine erste Zwischenschicht, die flächig mit dem Substrat verbunden ist,
- mindestens eine zweite Zwischenschicht, die flächig mit der ersten Zwischenschicht verbunden ist, und
- eine Deckscheibe, die flächig mit der zweiten Zwischenschicht verbunden ist,
wobei
- zwischen der ersten Zwischenschicht und der zweiten Zwischenschicht zumindest abschnittsweise eine Trägerfolie mit einer elektrisch leitfähigen Schicht angeordnet ist,
- ein kapazitiver Schaltbereich durch mindestens eine beschichtungsfreie Trennlinie aus der elektrisch leitfähigen Schicht elektrisch abgetrennt ist,
- der kapazitive Schaltbereich einen Berührungsbereich, einen Zuleitungsbereich und einen Anschlussbereich aufweist, der Zuleitungs-bereich den Berührungsbereich mit dem Anschlussbereich elektrisch verbindet und der Anschlussbereich mit einer Sensorelektronik elektrisch verbindbar ist, und
- der Flächenkapazitätsbelag c_{I} zwischen dem Berührungsbereich und der außenseitigen Oberfläche des Substrats größer als der Flächenkapazitätsbelag c_{A} zwischen dem Berührungsbereich und der außenseitigen Oberfläche der Deckscheibe ist.

Der Flächenkapazitätsbelag c_{I} beziehungsweise c_{A} ist definiert als die Kapazität eines Plattenkondensators desjenigen Bereichs der Verbundscheibe, der sich durch orthogonale Projektion des Berührungsbereichs zwischen dem Berührungsbereich und der außenseitigen Oberfläche des Substrats beziehungsweise der außenseitigen Oberfläche der Deckscheibe ergibt, wobei die sich ergebende Kapazität auf die Fläche des Berührungsbereichs normiert wird. Außenseitige Oberfläche bedeutet hierbei die Oberfläche der Verbundscheibe die nach Außen, also von der Verbundscheibe weg weißt. Innenseitige Oberfläche bedeutet demnach die Oberfläche des Substrats oder der Deckscheibe, die ins Innere der Verbundscheibe weist und mit einer Zwischenschicht flächig verbunden ist.

Der Flächenkapazitätsbelag ist folglich die auf die Fläche (und insbesondere auf die oben genannte orthogonale Projektionsfläche) normierte Kapazität der gesamten Schichtfolgen (Belag) zwischen der elektrisch leitfähigen Schicht und der jeweiligen außenseitigen Oberfläche der Verbundscheibe.

In einer vorteilhaften Ausgestaltung der Erfindung beträgt das Verhältnis von Länge l_{Z} zu Breite b_{Z} des Zuleitungsbereichs kleiner oder gleich 1:700 und bevorzugt von 1:1 bis 1:100. Weist der Zuleitungsbereich keine konstante Breite b_{Z} auf, beispielsweise wenn er trapezförmig oder tropfenförmig ausgebildet ist, so wird im Rahmen der vorliegenden Erfindung unter der Breite b_{Z} die gemittelte Breite des Zuleitungsbereichs verstanden.

Die Länge l_{Z} des Zuleitungsbereichs beträgt bevorzugt von 1 cm bis 70 cm und besonders bevorzugt von 3 cm bis 8 cm. Die Breite b_{Z} des Zuleitungsbereichs beträgt bevorzugt von 0,5 mm bis 10 mm und besonders bevorzugt von 0,5 mm bis 2 mm. Die Form des Zuleitungsbereichs ist bevorzugt rechteckförmig, streifenförmig oder linienförmig.

In einer vorteilhaften Ausgestaltung der erfindungsgemäßen Verbundscheibe ist der Anschlussbereich am äußeren Rand der Scheibe angeordnet. Dabei beträgt der Abstand zum äußeren Rand bevorzugt weniger als 10 cm, besonders bevorzugt weniger als 0,5 cm. Dies erlaubt es eine elektrische Kontaktierung des Anschlussbereichs, beispielsweise mit einem Folienleiter, unter einem optisch unauffälligen Schwarzdruck oder mit einer Abdeckung, beispielsweise einem Kameragehäuse zu kaschieren.

In einer vorteilhaften Ausgestaltung des erfindungsgemäßen Schaltbereichs hat der Berührungsbereich eine Fläche von 1 cm² bis 200 cm², besonders bevorzugt von 1 cm² bis 9 cm². Die Länge l_{B} des Berührungsbereichs beträgt bevorzugt von von 1 cm bis 14 cm und besonders bevorzugt von 1 cm bis 3 cm. Die maximale Breite b_{B} des Berührungsbereichs beträgt bevorzugt von 1 cm bis 14 cm und besonders bevorzugt von 1 cm bis 3 cm. Der Berührungsbereich kann prinzipiell jede beliebige Form aufweisen. Besonders geeignete Berührungsbereiche sind kreisförmig, elliptisch oder tropfenförmig ausgebildet. Alternativ sind eckige Formen möglich, beispielsweise Dreiecke, Quadrate, Rechtecke, Trapeze oder anders geartete Vierecke oder Polygone höherer Ordnung. Allgemein ist es besonders vorteilhaft, wenn etwaige Ecken abgerundet sind. Dies gilt für alle Bereiche des Schaltbereichs insbesondere im Übergangsbereich zwischen Berührungsbereich und Zuleitungsbereich und/oder Zuleitungsbereich und Anschlussbereich. Besonders vorteilhaft ist es, wenn die Ecken einen Krümmungsradius von mindestens 3 mm, bevorzugt von mindestens 8 mm aufweisen.

In einer weiteren vorteilhaften Ausgestaltung des erfindungsgemäßen Schaltbereichs beträgt das Verhältnis der Breite b_{Z} des Zuleitungsbereichs zur maximalen Breite b_{B} des Berührungsbereichs von mindestens 1:2 und insbesondere von mindestens 1:10. Dadurch konnten besonders gute Schaltergebnisse erzielt werden.

In einer vorteilhaften Ausgestaltung der erfindungsgemäßen Scheibe, beträgt die Breite t₁ der Trennlinien von 30 µm bis 200 µm und bevorzugt von 70 µm bis 140 µm. Derartig dünne Trennlinien erlauben eine sichere und ausreichend hohe elektrische Isolierung und stören gleichzeitig die Durchsicht durch die Verbundscheibe nicht oder nur geringfügig.

Der Schaltbereich ist ein kapazitiver Schaltbereich, das heißt er ist besonders für eine kapazitive Berührungsdetektion ausgebildet. In einer vorteilhaften Ausgestaltung bildet der Schaltbereich dabei eine Flächenelektrode aus. Über eine externe kapazitive Sensorelektronik wird die Kapazität der Flächenelektrode gemessen. Die Kapazität der Flächenelektrode ändert sich gegen Erde, wenn ein Körper (beispielsweise ein menschlicher Körper), in ihre Nähe kommt oder beispielsweise eine Isolatorschicht über der Flächenelektrode berührt. Die Isolatorschicht umfasst insbesondere das Substrat selbst. Die Kapazitätsänderung wird durch die Sensorelektronik gemessen und bei Überschreiten eines Schwellwerts wird ein Schaltsignal ausgelöst. Der Schaltbereich wird durch Form und Größe der Flächenelektrode festgelegt.

Der Bereich der elektrisch leitfähigen Schicht, der außerhalb des kapazitiven Schaltbereichs angeordnet ist - im Folgenden Umgebungsbereich genannt - kann über einen weiteren Anschlussbereich mit der Sensorelektronik verbindbar sein.

In einer solchen Anordnung bilden der kapazitive Schaltbereich und der Umgebungsbereich zwei Elektroden aus, die kapazitiv miteinander gekoppelt sind. Die Kapazität des von den Elektroden gebildeten Kondensators ändert sich bei Annäherung eines Körpers, beispielsweise eines menschlichen Körperteils. Die Kapazitätsänderung wird durch eine Sensorelektronik gemessen und bei Überschreiten eines Schwellwerts wird ein Schaltsignal ausgelöst. Der sensitive Bereich wird durch Form und Größe des Bereichs, in denen die Elektroden kapazitiv gekoppelt sind, festgelegt.

Der erfindungsgemäße kapazitive Schaltbereich und gegebenenfalls der Umgebungsbereich sind in die erfindungsgemäße Verbundscheibe integriert. Es ist also kein Schalter oder ähnliches als separates Bauteil nötig, welches an der Verbundscheibe angebracht werden muss. Die Verbundscheibe weist bevorzugt auch keine sonstigen Bauteile auf, die im Durchsichtbereich auf ihren Oberflächen angeordnet sind. Das ist besonders vorteilhaft im Hinblick auf eine dünne Bauweise der Verbundscheibe sowie einer nur geringen Störung der Durchsicht durch die Verbundscheibe.

Ein vorteilhafter Aspekt der Erfindung umfasst eine Scheibenanordnung mit einer erfindungsgemäßen Verbundscheibe und einer Sensorelektronik, die über den Anschlussbereich mit dem kapazitiven Schaltbereich und gegebenenfalls über einen weiteren Anschlussbereich mit der Umgebungsfläche elektrisch verbunden ist. Die Sensorelektronik ist eine kapazitive Sensorelektronik.

In einer vorteilhaften Ausgestaltung der erfindungsgemäßen Schaltanordnung ist die Empfindlichkeit der Sensorelektronik so gewählt, dass die Sensorelektronik bei Berührung des Berührungsbereichs mit einem menschlichen Finger auf dem Substrat ein Schaltsignal ausgibt und bei Berührung des Berührungsbereichs auf der Deckscheibe kein Schaltsignal oder ein anderes Schaltsignal ausgibt. Es versteht sich, dass die Berührung des Berührungsbereichs auch mit mehreren Fingern oder einem anderen menschlichen Körperteil erfolgen kann. Unter Berührung wird im Rahmen dieser Erfindung jegliche Wechselwirkung mit dem Schaltbereich verstanden, die zu einer messbaren Änderung des Messsignals, also hier der Kapazität, führt. Insbesondere ist dies eine Berührung einer außenseitigen Oberfläche der Verbundscheibe in einer Zone, die sich durch orthogonale Projektion des Berührungsbereichs auf der außenseitigen Oberfläche ergibt.

In einer vorteilhaften Ausgestaltung der erfindungsgemäßen Verbundscheibe ist das Verhältnis des Flächenkapazitätsbelags c_{I} zum Flächenkapazitätsbelag c_{A} größer oder gleich 1,1:1, bevorzugt größer oder gleich 1,2:1, beträgt. Für derartige Verhältnisse lässt sich eine Berührung der außenseitigen Oberfläche des Substrats bereits gut von einer Berührung der außenseitigen Oberfläche der Deckscheibe unterscheiden.

Die ausgegebenen Schaltsignale können beliebig und den Erfordernissen der jeweiligen Verwendung angepasst sein. So kann das Schaltsignal eine positive Spannung, beispielsweise 12 V, bedeuten, kein Schaltsignal beispielsweise 0 V bedeuten und ein anderes Schaltsignal beispielweise + 6V bedeuten. Die Schaltsignale können auch den bei einem CAN-Bus üblichen Spannungen CAN_High und CAN_Low entsprechen und um einen dazwischen liegenden Spannungswert wechseln. Das Schaltsignal kann auch gepulst und/oder digital codiert sein.

Die Empfindlichkeit der Sensorelektronik kann in Abhängigkeit der Größe des Berührungsbereichs und in Abhängigkeit der Dicke von Substrat, Zwischenschichten und Deckscheibe im Rahmen einfacher Experimente ermittelt werden.

Der besondere Vorteil einer solchen erfindungsgemäßen Scheibenanordnung liegt darin, dass das Schaltsignal nur bei Berührung der Verbundscheibe von einer der außenseitigen Oberflächen ausgelöst werden kann. Bei einer Verwendung der Scheibenanordnung in einer Fahrzeugscheibe und Einbau der Verbundscheibe mit der Substratseite in Richtung des Fahrzeuginnenraums, kann beispielsweise ein Auslösen des Schaltvorgangs durch Personen von außen oder ein ungewolltes Auslösen des Schaltvorgangs durch Regen oder die Bewegung des Scheibenwischers sicher vermieden werden, ohne den generell üblichen Scheibenaufbau für Verbundsicherheitsglas grundlegend zu verändern. Dies war für den Fachmann unerwartet und überraschend.

In Kombination mit der soeben beschriebenen Scheibenanordnung oder alternativ dazu, kann die Empfindlichkeit der Sensorelektronik so gewählt werden, dass sie bei Berührung des Berührungsbereichs auf dem Substrat und/oder der Deckscheibe mit einem menschlichen Finger ein Schaltsignal ausgibt und bei Berührung des Zuleitungsbereichs auf dem Substrat und/oder der Deckscheibe kein Schaltsignal oder ein anderes Schaltsignal ausgibt.

Die Empfindlichkeit der Sensorelektronik kann in Abhängigkeit der Größe des Berührungsbereichs und in Abhängigkeit der Geometrie sowie des Aspektverhältnisses zwischen Breite und Länge des Zuleitungsbereichs im Rahmen einfacher Experimente ermittelt werden. Besonders vorteilhaft ist es dabei, wenn die Breite des Zuleitungsbereichs möglichst gering gewählt wird.

Der besondere Vorteil dieser Ausführungsform einer erfindungsgemäßen Scheibenanordnung liegt darin, dass das Schaltsignal nur bei Berührung der außenseitigen Oberfläche der Verbundscheibe über dem Berührungsbereich oder seiner unmittelbaren Umgebung ausgelöst werden kann und so eine präzise Steuerung des Schaltvorgangs möglich ist und beispielsweise ein versehentliches Schalten vermieden wird.

In einer vorteilhaften Weiterbildung einer erfindungsgemäßen Scheibenanordnung ist der Anschlussbereich mit einem Flachleiter verbunden und der Flachleiter ist aus der Scheibe herausgeführt. Die integrierte Scheibenanordnung kann dann besonders einfach am Verwendungsort mit einer Spannungsquelle und einer Signalleitung verbunden werden, die das Schaltsignal der Sensorschaltung auswertet, beispielsweise in einem Fahrzeug über einen CAN-Bus.

Als Substrat und Deckscheibe sind im Grunde alle elektrisch isolierenden Substrate geeignet, die unter den Bedingungen der Herstellung und der Verwendung der erfindungsgemäßen Verbundscheibe thermisch und chemisch stabil sowie dimensionsstabil sind.

Das Substrat und/oder die Deckscheibe enthalten bevorzugt Glas, besonders bevorzugt Flachglas, Floatglas, Quarzglas, Borosilikatglas, Kalk-Natron-Glas, oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon. Das Substrat und/oder die Deckscheibe sind bevorzugt transparent, insbesondere für die Verwendung der Scheibe als Windschutzscheibe oder Rückscheibe eines Fahrzeugs oder anderen Verwendungen bei denen eine hohe Lichttransmission erwünscht ist. Als transparent im Sinne der Erfindung wird dann eine Scheibe verstanden, die eine Transmission im sichtbaren Spektralbereich von größer 70 % aufweist. Für Scheiben, die nicht im verkehrrelevanten Sichtfeld des Fahrers liegen, beispielsweise für Dachscheiben, kann die Transmission aber auch viel geringer sein, beispielsweise größer als 5 %.

Die Dicke von Substrat und/oder Deckscheibe kann breit variieren und so hervorragend den Erfordernissen des Einzelfalls angepasst werden. Vorzugsweise werden Standardstärken von 1,0 mm bis 25 mm, bevorzugt von 1,4 mm bis 2,5 mm für Fahrzeugglas und bevorzugt von 4 mm bis 25 mm für Möbel, Geräte und Gebäude, insbesondere für elektrische Heizkörper, verwendet. Die Größe der Scheibe kann breit variieren und richtet sich nach der Größe der erfindungsgemäßen Verwendung. Das Substrat und gegebenenfalls die Deckscheibe weisen beispielsweise im Fahrzeugbau und Architekturbereich übliche Flächen von 200 cm² bis zu 20 m² auf.

Die Verbundscheibe kann eine beliebige dreidimensionale Form aufweisen. Vorzugsweise hat die dreidimensionale Form keine Schattenzonen, so dass sie beispielsweise durch Kathodenzerstäubung beschichtet werden kann. Bevorzugt sind die Substrate planar oder leicht oder stark in einer Richtung oder in mehreren Richtungen des Raumes gebogen. Insbesondere werden planare Substrate verwendet. Die Scheiben können farblos oder gefärbt sein.

Das Substrat und/oder die Deckscheibe weisen bevorzugt eine relative Permittivität ε_{r,1/4} von 2 bis 8 und besonders bevorzugt von 6 bis 8 auf. Bei derartigen relativen Permittivitäten konnte eine besonders gute Unterscheidung zwischen einer Berührung der Berührungsfläche über die außenseitige Oberfläche des Substrats von gegenüber der außenseitigen Oberfläche der Deckscheibe erzielt werden.

Substrate und/oder Deckscheiben werden durch mindestens eine erste und eine zweite Zwischenschicht miteinander verbunden. Die Zwischenschicht ist bevorzugt transparent. Die Zwischenschicht enthält vorzugsweise mindestens einen Kunststoff, bevorzugt Polyvinylbutyral (PVB), Ethylenvinylacetat (EVA) und / oder Polyethylenterephthalat (PET). Die Zwischenschicht kann aber auch beispielsweise Polyurethan (PU), Polypropylen (PP), Polyacrylat, Polyethylen (PE), Polycarbonat (PC), Polymethylmetacrylat, Polyvinylchlorid, Polyacetatharz, Gießharze, Acrylate, fluorinierte Ethylen-Propylene, Polyvinylfluorid und/oder Ethylen-Tetrafluorethylen, oder Copolymere oder Gemische davon enthalten. Die Zwischenschicht kann durch eine oder auch durch mehrere übereinander angeordnete Folien ausgebildet werden, wobei die Dicke einer Folie bevorzugt von 0,025 mm bis 1 mm beträgt, typischerweise 0,38 mm oder 0,76 mm. Die Zwischenschichten können bevorzugt thermoplastisch sein und nach der Lamination das Substrat, die Deckscheibe und eventuelle weitere Zwischenschichten miteinander verkleben. In einer besonders vorteilhaften Ausgestaltung der erfindungsgemäßen Verbundscheibe ist die erste Zwischenschicht als Klebeschicht aus einem Klebstoff ausgebildet, mit der die Trägerfolie auf dem Substrat aufgeklebt ist. In diesem Fall hat die erste Zwischenschicht bevorzugt die Abmessungen der Trägerfolie.

Die Zwischenschicht hat bevorzugt eine relative Permittivität von 2 bis 4 und besonders bevorzugt von 2,1 bis 2,9. Bei derartigen relativen Permittivitäten konnte eine besonders gute Unterscheidung zwischen einer Berührung der Berührungsfläche über die außenseitige Oberfläche des Substrats von gegenüber der außenseitigen Oberfläche der Deckscheibe erzielt werden.

Die erfindungsgemäße Trägerfolie ist bevorzugt transparent. Sie enthält bevorzugt eine Polyethylenterepthalat (PET)-Folie oder besteht daraus. Die Dicke der Trägerfolie beträgt bevorzugt von 0,025 mm bis 0,1 mm. Die Trägerfolie hat bevorzugt eine relative Permittivität von 2 bis 4 und besonders bevorzugt von 2,7 bis 3,3. Mit derartigen Trägerfolien lassen sich besonders gute Verbundscheiben herstellen, da derart dünne Trägerfolien auch bei nur abschnittsweiser Anordnung gut und optisch unauffällig in der Verbundscheibe integrierbar sind. Gleichzeit lassen sich gute und selektive Schaltsignale erzeugen. Die erfindungsgemäße elektrisch leitfähige Schicht ist bevorzugt auf einer Oberfläche der Trägerfolie angeordnet, das heißt auf genau einer der beiden Seiten der Trägerfolie (also auf deren Vorderseite oder deren Rückseite).

Die Begriffe "Substrat" und "Deckscheibe" sind zur Unterscheidung der beiden Scheiben bei einer erfindungsgemäßen Verbundscheibe gewählt. Mit den Begriffen ist keine Aussage über die geometrische Anordnung verbunden. Ist die erfindungsgemäße Verbundscheibe beispielsweise dafür vorgesehen, in einer Öffnung, beispielsweise eines Fahrzeugs oder eines Gebäudes, den Innenraum gegenüber der äußeren Umgebung abzutrennen, so kann das Substrat dem Innenraum oder der äußeren Umgebung zugewandt sein.

Die elektrisch leitfähige Schicht enthält bevorzugt eine transparente, elektrisch leitfähige Beschichtung. Transparent bedeutet hier durchlässig für elektromagnetische Strahlung, vorzugsweise elektromagnetische Strahlung einer Wellenlänge von 300 nm bis 1.300 nm und insbesondere für sichtbares Licht.

Erfindungsgemäße elektrisch leitfähige Schichten sind beispielsweise aus DE 20 2008 017 611 U1, EP 0 847 965 B1 oder WO2012/052315 A1 bekannt. Sie enthalten typischerweise eine oder mehrere, beispielsweise zwei, drei oder vier elektrisch leitfähige, funktionelle Schichten. Die funktionellen Schichten enthalten bevorzugt zumindest ein Metall, beispielsweise Silber, Gold, Kupfer, Nickel und/oder Chrom, oder eine Metalllegierung. Die funktionellen Schichten enthalten besonders bevorzugt mindestens 90 Gew. % des Metalls, insbesondere mindestens 99,9 Gew. % des Metalls. Die funktionellen Schichten können aus dem Metall oder der Metalllegierung bestehen. Die funktionellen Schichten enthalten besonders bevorzugt Silber oder eine silberhaltige Legierung. Solche funktionelle Schichten weisen eine besonders vorteilhafte elektrische Leitfähigkeit bei gleichzeitiger hoher Transmission im sichtbaren Spektralbereich auf. Die Dicke einer funktionellen Schicht beträgt bevorzugt von 5 nm bis 50 nm, besonders bevorzugt von 8 nm bis 25 nm. In diesem Bereich für die Dicke der funktionellen Schicht wird eine vorteilhaft hohe Transmission im sichtbaren Spektralbereich und eine besonders vorteilhafte elektrische Leitfähigkeit erreicht.

Typischerweise ist jeweils zwischen zwei benachbarten funktionellen Schichten zumindest eine dielektrische Schicht angeordnet. Bevorzugt ist unterhalb der ersten und/oder oberhalb der letzten funktionellen Schicht eine weitere dielektrische Schicht angeordnet. Eine dielektrische Schicht enthält zumindest eine Einzelschicht aus einem dielektrischen Material, beispielsweise enthaltend ein Nitrid wie Siliziumnitrid oder ein Oxid wie Aluminiumoxid. Die dielektrische Schicht kann aber auch mehrere Einzelschichten umfassen, beispielsweise Einzelschichten aus einem dielektrischen Material, Glättungsschichten, Anpassungsschichten, Blockerschichten und / oder Antireflexionsschichten. Die Dicke einer dielektrischen Schicht beträgt beispielsweise von 10 nm bis 200 nm.

Dieser Schichtaufbau wird im Allgemeinen durch eine Folge von Abscheidevorgängen erhalten, die durch ein Vakuumverfahren wie die magnetfeldgestützte Kathodenzerstäubung durchgeführt werden.

Weitere geeignete elektrisch leitfähige Schichten enthalten bevorzugt Indium-Zinnoxid (ITO), fluordotiertes Zinnoxid (SnO₂:F) oder aluminiumdotiertes Zinkoxid (ZnO:Al).

Die elektrisch leitfähige Schicht kann prinzipiell jede Beschichtung sein, die elektrisch kontaktiert werden kann. Soll die erfindungsgemäße Scheibe die Durchsicht ermöglichen, wie es beispielsweise bei Scheiben im Fensterbereich der Fall ist, so ist die elektrisch leitfähige Schicht bevorzugt transparent. In einer vorteilhaften Ausgestaltung ist die elektrisch leitfähige Schicht eine Schicht oder ein Schichtaufbau mehrerer Einzelschichten mit einer Gesamtdicke von kleiner oder gleich 2 µm, besonders bevorzugt kleiner oder gleich 1 µm.

Eine vorteilhafte erfindungsgemäße transparente elektrisch leitfähige Schicht weist einen Flächenwiderstand von 0,4 Ohm/Quadrat bis 200 Ohm/Quadrat auf. In einer besonders bevorzugten Ausgestaltung weist die erfindungsgemäße elektrisch leitfähige Schicht einen Flächenwiderstand von 0,5 Ohm/Quadrat bis 20 Ohm/Quadrat auf. Beschichtungen mit derartigen Flächenwiderständen eignen sich besonders zur Beheizung von Fahrzeugscheiben bei typischen Bordspannungen von 12 V bis 48 Volt oder bei Elektrofahrzeugen mit typischen Bordspannungen von bis zu 500 V.

Die elektrisch leitfähige Schicht kann sich über die gesamte Oberfläche einer Seite der Trägerfolie erstrecken. Die elektrisch leitfähige Schicht kann sich alternativ aber auch nur über einen Teil der Oberfläche der Trägerfolie erstrecken. Die elektrisch leitfähige Schicht kann eine oder mehrere unbeschichtete Zonen aufweisen. Diese Zonen können für elektromagnetische Strahlung durchlässig sein und sind beispielsweise als Datenübertragungsfenster oder Kommunikationsfenster bekannt.

In einer vorteilhaften Ausgestaltung einer erfindungsgemäßen Verbundscheibe ist die elektrisch leitfähige Schicht um eine Breite von 2 mm bis 50 mm, bevorzugt von 5 mm bis 20 mm vom Rand der Verbundscheibe entfernt angeordnet. Die elektrisch leitfähige Schicht weist dann keinen Kontakt zur Atmosphäre auf und ist im Inneren der Verbundscheibe durch die Zwischenschichten vorteilhaft vor Beschädigungen und Korrosion geschützt.

Die elektrische Zuleitung ist bevorzugt als Folienleiter oder flexibler Folienleiter (Flachleiter, Flachbandleiter) ausgebildet. Unter Folienleiter wird ein elektrischer Leiter verstanden, dessen Breite deutlich größer ist als seine Dicke. Ein solcher Folienleiter ist beispielsweise ein Streifen oder Band enthaltend oder bestehend aus Kupfer, verzinntem Kupfer, Aluminium, Silber, Gold oder Legierungen davon. Der Folienleiter weist beispielsweise eine Breite von 2 mm bis 16 mm und eine Dicke von 0,03 mm bis 0,1 mm auf. Der Folienleiter kann eine isolierende, bevorzugt polymere Ummantelung, beispielsweise auf Polyimid-Basis aufweisen. Folienleiter, die sich zur Kontaktierung von elektrisch leitfähigen Beschichtungen in Scheiben eignen, weisen lediglich eine Gesamtdicke von beispielsweise 0,3 mm auf. Derart dünne Folienleiter können ohne Schwierigkeiten zwischen den einzelnen Scheiben in der thermoplastischen Zwischenschicht eingebettet werden. In einem Folienleiterband können sich mehrere voneinander elektrisch isolierte, leitfähige Schichten befinden.

Alternativ können auch dünne Metalldrähte als elektrische Zuleitung verwendet werden. Die Metalldrähte enthalten insbesondere Kupfer, Wolfram, Gold, Silber oder Aluminium oder Legierungen mindestens zweier dieser Metalle. Die Legierungen können auch Molybdän, Rhenium, Osmium, Iridium, Palladium oder Platin enthalten.

Die elektrische Leitungsverbindung zwischen dem Anschlussbereiche der elektrisch leitfähigen Schicht auf der Trägerfolie und der elektrischen Zuleitung erfolgt bevorzugt über elektrisch leitfähige Kleber, die eine sichere und dauerhaft elektrische Leitungsverbindung zwischen Anschlussbereich und Zuleitung ermöglichten. Alternativ kann die elektrische Leitungsverbindung auch durch Klemmen erfolgen, da die Klemmverbindung durch den Laminiervorgang verrutschungssicher fixiert wird. Alternativ kann die Zuleitung auch auf den Anschlussbereich aufgedruckt werden, beispielsweise mittels einer metallhaltigen und insbesondere silberhaltigen, elektrisch leitfähigen Druckpaste.

In einer vorteilhaften Ausgestaltung der Erfindung weist die erfindungsgemäße Verbundscheibe ein Lichteinstrahlmittel und ein Lichtablenkmittel auf. Lichteinstrahlmittel und Lichtablenkmittel sind dabei in oder am Substrat und/oder an der Deckscheibe oder zwischen den Zwischenschichten beziehungsweise der Trägerfolie angeordnet.

Das Lichteinstrahlmittel umfasst erfindungsgemäß zumindest eine Lichtquelle, bevorzugt eine LED oder OLED. Der besondere Vorteil liegt in den kleinen Abmessungen und der geringen Leistungsaufnahme. Der von der Lichtquelle emittierte Wellenlängenbereich kann im Bereich des sichtbaren Lichtes frei gewählt werden, beispielsweise nach praktischen und / oder ästhetischen Gesichtspunkten. Das Lichteinstrahlmittel kann optische Elemente umfassen, insbesondere zur Lenkung des Lichts, bevorzugt einen Reflektor und / oder einen Lichtwellenleiter, beispielsweise eine Glasfaser oder eine polymere optische Faser. Das Lichteinstrahlmittel kann an einer beliebigen Stelle des Substrats oder der Deckscheibe angeordnet sein, insbesondere am Seitenrand des Substrats oder der Deckscheibe oder in einer kleinen Ausnehmung inmitten von Substrat oder Deckscheibe.

Das Lichtablenkmittel umfasst bevorzugt Partikel, Punktraster, Aufkleber, Anlagerungen, Einkerbungen, Einritzungen, Strichraster, Aufdrucke und / oder Siebdrucke und ist dazu geeignet das im Substrat oder in der Deckscheibe transportierte Licht aus demselben auszukoppeln.

Das Lichtablenkmittel kann an jeder beliebigen Position auf der Ebene des Substrats oder der Deckscheibe angeordnet sein. Besonders vorteilhaft ist es, wenn das Lichtablenkmittel im Bereich oder in der unmittelbaren Umgebung des Berührungsbereichs angeordnet ist und so ein schnelles Auffinden des ansonsten kaum sichtbaren Berührungsbereichs ermöglicht. Dies ist insbesondere bei Nacht oder Dunkelheit besonders vorteilhaft.

Alternativ kann Licht durch einen Lichtleiter, der auf dem Substrat, der Zwischenschicht oder der Deckscheibe angeordnet ist, an den Berührungsbereich herangeführt werden und diesen markieren.

Alternativ oder in Kombination kann das Lichteinstrahlmittel zusammen mit dem Lichtablenkmittel eine Information auf der Scheibe visualisieren, beispielsweise den Schaltzustand des kapazitiven Schaltbereichs wiedergeben oder anzeigen, ob beispielsweise eine elektrische Funktion eingeschaltet oder ausgeschaltet ist.

In einer alternativen vorteilhaften Ausgestaltung der erfindungsgemäßen Verbundscheibe ist der Berührungsbereich durch eine aktive Lichtquelle direkt markierbar oder markiert, bevorzugt durch eine Leuchtdiode (LED), eine organische Leuchtdiode (OLED), eine Glühbirne oder andere aktive Leuchtkörper, wie ein lumineszentes Material, bevorzugt ein fluoreszierende oder phosphoreszierendes Material.

In einer weiteren alternativen vorteilhaften Ausgestaltung der erfindungsgemäßen Verbundscheibe ist der Berührungsbereich durch einen farbigen, bevorzugt einen weißen oder schwarzen, Aufdruck, beispielsweise einem Siebdruck, auf dem transparenten Substrat, der Zwischenschicht oder der Deckscheibe, markiert. Dies hat den besonderen Vorteil, dass der Berührungsbereich unabhängig von einer Spannungsquelle und dauerhaft markiert ist. Der Aufdruck kann auch ein lumineszentes Material, bevorzugt ein fluoreszierende oder phosphoreszierendes Material enthalten und/oder nachleuchtend sein.

Ein weiterer Aspekt der Erfindung umfasst ein Verfahren zur Herstellung einer Verbundscheibe mit kapazitivem Schaltbereich, mindestens umfassend:
(a) Aufbringen einer elektrisch leitfähigen Schicht auf einer Oberfläche einer Trägerfolie,
(b) Einbringen mindestens einer Trennlinie, die die elektrisch leitfähige Schicht in mindestens einen kapazitiven Schaltbereich und mindestens einen Umgebungsbereich elektrisch unterteilt, bevorzugt durch Laserstrukturierung oder durch mechanisches oder chemisches Abtragen, und
(c) Herstellen einer Stapelfolge aus einem Substrat, einer ersten Zwischenschicht, einer zweiten Zwischenschicht und einer Deckscheibe, wobei die Trägerfolie zumindest abschnittsweise zwischen der ersten Zwischenschicht und der zweiten Zwischenschicht angeordnet wird,
(d) Laminieren der Stapelfolge zu einer Verbundscheibe.

Das Aufbringen der elektrisch leitfähigen Schicht in Verfahrensschritt (a) kann durch an sich bekannte Verfahren erfolgen, bevorzugt durch magnetfeldunterstützte Kathodenzerstäubung. Das ist besonders vorteilhaft im Hinblick auf eine einfache, schnelle, kostengünstige und gleichmäßige Beschichtung des Substrats. Die elektrisch leitfähigen Schicht kann aber auch beispielsweise durch Aufdampfen, chemische Gasphasenabscheidung (chemical vapour deposition, CVD), plasmagestützte Gasphasenabscheidung (PECVD) oder durch nasschemische Verfahren aufgebracht werden.

Die Trägerfolie kann nach Verfahrensschritt (a) einer Temperaturbehandlung unterzogen werden. Dabei wird die Trägerfolie mit der elektrisch leitfähigen Schicht auf eine Temperatur von mindestens 200°C, bevorzugt mindestens 300°C erwärmt. Die Temperaturbehandlung kann der Erhöhung der Transmission und / oder der Verringerung des Flächenwiderstands der elektrisch leitfähigen Schicht dienen.

Die Entschichtung einzelner Trennlinien in der elektrisch leitfähigen Schicht erfolgt vorzugsweise durch einen Laserstrahl. Verfahren zum Strukturieren dünner Metallfilme sind beispielsweise aus EP 2 200 097 A1 oder EP 2 139 049 A1 bekannt. Die Breite der Entschichtung beträgt bevorzugt 10 µm bis 1000 µm, besonders bevorzugt 30 µm bis 200 µm und insbesondere 70 µm bis 140 µm. In diesem Bereich findet eine besonders saubere und rückstandsfreie Entschichtung durch den Laserstrahl statt. Die Entschichtung mittels Laserstrahl ist besonders vorteilhaft, da die entschichteten Linien optisch sehr unauffällig sind und das Erscheinungsbild und die Durchsicht nur wenig beeinträchtigen. Die Entschichtung einer Linie mit einer Breite, die breiter ist als die Breite eines Laserschnitts, erfolgt durch mehrmaliges Abfahren der Linie mit dem Laserstrahl. Die Prozessdauer und die Prozesskosten steigen deshalb mit zunehmender Linienbreite an. Alternativ kann die Entschichtung durch mechanisches Abtragen sowie durch chemisches oder physikalisches Ätzen erfolgen.

Die erste beziehungsweise die zweite Zwischenschicht kann durch eine einzelne oder auch durch zwei oder mehrere Folien, die flächenmäßig übereinander angeordnet werden, ausgebildet werden.

Das Verbinden von Substrat und Deckscheibe in Verfahrensschritt (d) erfolgt bevorzugt unter Einwirkung von Hitze, Vakuum und/oder Druck. Es können an sich bekannte Verfahren zur Herstellung einer Verbundscheibe verwendet werden.

Es können beispielsweise sogenannte Autoklavverfahren bei einem erhöhten Druck von etwa 10 bar bis 15 bar und Temperaturen von 130 °C bis 145 °C über etwa 2 Stunden durchgeführt werden. An sich bekannte Vakuumsack- oder Vakuumringverfahren arbeiten beispielsweise bei etwa 200 mbar und 80 °C bis 110 °C. Die erste Scheibe, die thermoplastische Zwischenschicht und die zweite Scheibe können auch in einem Kalander zwischen mindestens einem Walzenpaar zu einer Scheibe verpresst werden. Anlagen dieser Art sind zur Herstellung von Scheiben bekannt und verfügen normalerweise über mindestens einen Heiztunnel vor einem Presswerk. Die Temperatur während des Pressvorgangs beträgt beispielsweise von 40 °C bis 150 °C. Kombinationen von Kalander- und Autoklavverfahren haben sich in der Praxis besonders bewährt. Alternativ können Vakuumlaminatoren eingesetzt werden. Diese bestehen aus einer oder mehreren beheizbaren und evakuierbaren Kammern, in denen die erste Scheibe und die zweite Scheibe innerhalb von beispielsweise etwa 60 Minuten bei verminderten Drücken von 0,01 mbar bis 800 mbar und Temperaturen von 80°C bis 170°C laminiert werden.

Ein weiterer Aspekt der Erfindung umfasst die Verwendung der erfindungsgemäßen elektrisch beheizbaren Scheibe mit kapazitivem Schaltbereich in Gebäuden, insbesondere im Zugangsbereich, Fensterbereich, Dachbereich oder Fassadenbereich, als Einbauteil in Möbeln und Geräten, in Fortbewegungsmitteln für den Verkehr auf dem Lande, in der Luft oder zu Wasser, insbesondere in Zügen, Schiffen und Kraftfahrzeugen beispielsweise als Windschutzscheibe, Heckscheibe, Seitenscheibe und / oder Dachscheibe.

Im Folgenden wird die Erfindung anhand einer Zeichnung und Ausführungsbeispielen näher erläutert. Die Zeichnung ist eine schematische Darstellung und nicht maßstabsgetreu.

Es zeigen:
- Figur 1A: eine Draufsicht auf eine Ausgestaltung einer erfindungsgemäßen Scheibenanordnung mit einer erfindungsgemäßen Verbundscheibe,
- Figur 1B: eine Querschnittsdarstellung entlang der Schnittlinie A-A' aus Figur 1A,
- Figur 1C: eine vergrößerte Darstellung der erfindungsgemäßen Trägerfolie aus Figur 1A,
- Figur 1D: eine Querschnittsdarstellung entlang der Schnittlinie B-B' aus Figur 1C,
- Figur 2A: eine Draufsicht auf eine alternative Ausgestaltung einer erfindungsgemäßen Scheibenanordnung mit einer erfindungsgemäßen Verbundscheibe,
- Figur 2B: eine Querschnittsdarstellung entlang der Schnittlinie A-A' aus Figur 2A,
- Figur 2C: eine vergrößerte Darstellung der erfindungsgemäßen Trägerfolie aus Figur 2A,
- Figur 2D: eine Querschnittsdarstellung entlang der Schnittlinie B-B' aus Figur 2C, und
- Figur 3: ein detailliertes Flussdiagramm einer Ausführungsform des erfindungsgemäßen Verfahrens.

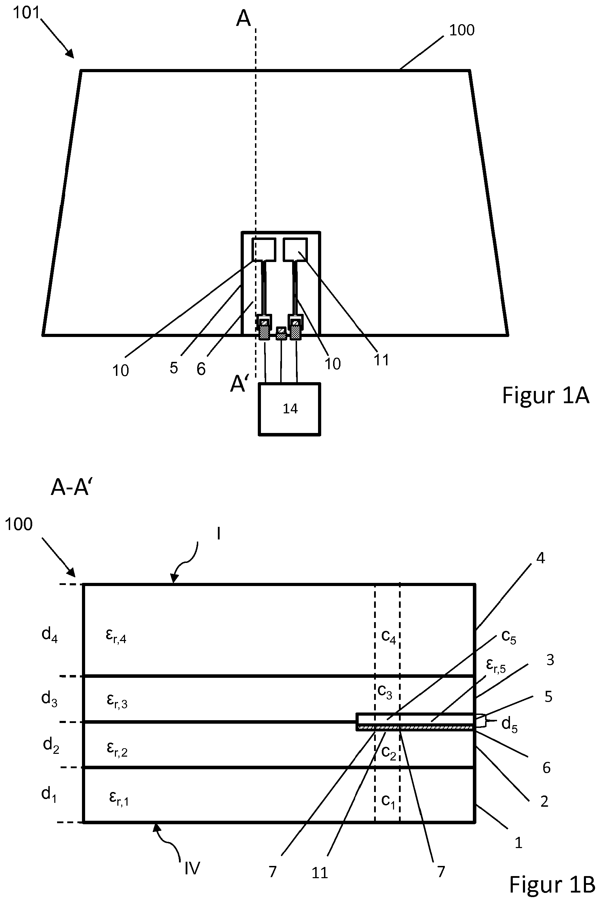

Figur 1A zeigt eine Draufsicht auf eine beispielhafte Ausgestaltung einer erfindungsgemäßen Scheibenanordnung 101 mit einer erfindungsgemäßen Verbundscheibe 100.

In Figur 1B ist eine Querschnittsdarstellung entlang der Schnittlinie A-A' aus Figur 1A dargestellt. Die Verbundscheibe 100 umfasst hier beispielsweise ein Substrat 1 und eine Deckscheibe 4, die über eine erste Zwischenschicht 2 und eine zweite Zwischenschicht 3 miteinander verbunden sind. Die Verbundscheibe 100 ist beispielsweise eine Fahrzeugscheibe und insbesondere die Windschutzscheibe eines Personenkraftwagens. Die Abmessungen der Verbundscheibe 100 betragen beispielsweise 0,9 m x 1,5 m. Das Substrat 1 ist beispielsweise dafür vorgesehen, in Einbaulage dem Innenraum zugewandt zu sein. Das heißt, die außenseitige Oberfläche IV des Substrats 1 ist vom Innenraum aus zugänglich, wogegen die außenseitige Oberfläche I der Deckscheibe 4 bezüglich des Fahrzeuginnenraums nach außen weist. Substrat 1 und Deckscheibe 4 bestehen beispielsweise aus Natron-Kalkglas. Die Dicke d₁ des Substrats 1 beträgt beispielsweise 1,6 mm und die Dicke d₄ der Deckscheibe 4 beträgt 2,1 mm. Es versteht sich, dass Substrat 1 und Deckscheibe 4 beliebige Dicken aufweisen können und beispielsweise auch gleich dick ausgebildet sein können. Die Zwischenschichten 2,3 sind thermoplastische Zwischenschichten und bestehen aus Polyvinylbutyral (PVB). Sie weisen jeweils eine Dicke d_{2/3} von 0,38 mm auf. Im mittleren, unteren Abschnitt der Verbundscheibe 100 ist zwischen der ersten Zwischenschicht 2 und der zweiten Zwischenschicht 3 eine Trägerfolie 5 mit einem kapazitiven Schaltbereich 10 angeordnet.

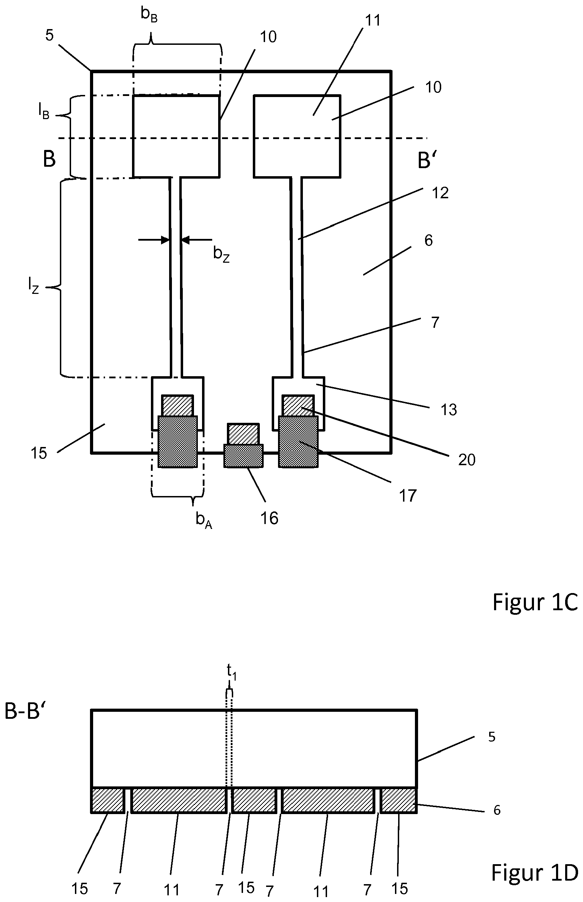

Figur 1C zeigt eine vergrößerte Darstellung der erfindungsgemäßen Trägerfolie 5 aus Figur 1A. Figur 1D zeigt eine dazugehörige Querschnittsdarstellung entlang der Schnittlinie B-B' aus Figur 1C.

Die Trägerfolie 5 ist in diesem Beispiel eine transparente Polyethylenterephthalat (PET)-Folie mit einer Dicke d₅ von 0,05 mm. Auf der Trägerfolie 5 ist eine transparente, elektrisch leitfähige Schicht 6 angeordnet. Die elektrische leitfähige Schicht 6 ist ein Schichtensystem, welches beispielsweise drei elektrisch leitfähige Silberschichten enthält, die durch dielektrische Schichten voneinander getrennt sind.

Die elektrisch leitfähige Schicht 6 erstreckt sich beispielsweise über eine gesamte Seite der Trägerfolie 5. Im dargestellten Ausführungsbeispiel ist die elektrisch leitfähige Schicht 6 auf derjenigen Seite der Trägerfolie 5 angeordnet, die dem Substrat 1 zugewandt ist. Die Trägerfolie 5 ist um einen Abstand von etwa 8 mm vom Scheibenrand ins Scheibeninnere versetzt. Dieser Bereich wird durch Verkleben der beiden Zwischenschichten 2,3 während des Laminierens hermetisch versiegelt, so dass die elektrisch leitfähige Schicht 6 vor Feuchtigkeit aus der Umgebung der Verbundscheibe 100 und damit vor Korrosion und Beschädigung geschützt ist. Alternativ wäre es möglich die Trägerfolie 5 in einem Randbereich beschichtungsfrei zu lassen oder die elektrisch leitfähige Schicht 6 dort zur entfernen.

Die elektrisch leitfähige Schicht 6 ist durch beschichtungsfreie Trennlinien 7 in unterschiedliche, voneinander elektrisch isolierte Bereiche unterteilt. In dem in Figur 1C dargestellten Beispiel sind zwei kapazitive Schaltbereiche 10 von einem gemeinsamen Umgebungsbereich 15 elektrisch unterteilt. Jeder Schaltbereich 10 umfasst einen Berührungsbereich 11, der annähernd quadratisch ausgebildet ist und in einen streifenförmigen Zuleitungsbereich 12 übergeht. Die Breite b_{B} und die Länge l_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form und einer Kantenlänge b_{A} von beispielsweise 12 mm. Die Länge l_{Z} des Zuleitungsbereichs beträgt etwa 48 mm.

Die Trennlinie 7 hat lediglich eine Breite t₁ von beispielsweise 100 µm und ist beispielsweise durch Laserstrukturierung in die elektrisch leitfähige Schicht 6 eingebracht. Trennlinien 7 mit einer derart geringen Breite sind optisch kaum wahrnehmbar und stören die Durchsicht durch die Verbundscheibe 100 nur wenig, was besonders für eine Verwendung in Fahrzeugen von besonderer Wichtigkeit für die Fahrsicherheit ist und außerdem besonders ästhetisch ist.

Der Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der Anschlussbereichs 13 mit einer Polyimidschicht isoliert. Dadurch kann der Folienleiter 17 ohne elektrischen Kurzschluss über den Umgebungsbereich 15 hinweg über den unteren Rand der Verbundscheibe 100 hinausgeführt werden. Es versteht sich, dass die elektrische Leitungsverbindung des Anschlussbereichs nach außen auch über isolierte Drähte oder über einen Bereich, in dem die elektrisch leitfähige Schicht des Umgebungsbereichs unterbrochen ist, nach außen geführt werden kann.

Der Folienleiter 17 ist hier beispielsweise außerhalb der Verbundscheibe 100 mit einer kapazitiven Sensorelektronik 14 verbunden. Des Weiteren ist der Umgebungsbereich 15 über einen weiteren Anschlussbereich 16 ebenfalls mit der Sensorelektronik 14 verbunden. Die Sensorelektronik 14 ist dazu geeignet Kapazitätsänderungen des Schaltbereichs 10 gegenüber dem Umgebungsbereich 15 präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann eine Beleuchtung in oder an der Verbundscheibe 100 ein- oder ausgeschaltet werden.

Wird die Verbundscheibe 100 beispielsweise als Windschutzscheibe in einem Kraftfahrzeug verwendet, kann die Länge des Zuleitungsbereichs 12 so gewählt werden, dass der Fahrer des Fahrzeugs oder der Beifahrer den Berührungsbereich 11 des Schaltbereichs 10 bequem erreichen.

Im dargestellten Ausgestaltungsbeispiel ist die Aufbau und die Abstimmung der Sensorelektronik 14 derart abgestimmt, dass bei Berührung der außenseitigen Scheibenoberfläche IV des Substrats 1 über dem Berührungsbereich 11 des kapazitiven Schaltbereichs 10 ein Schaltsignal ausgelöst wird, wobei bei Berührung der außenseitigen Scheibenoberfläche I der Deckscheibe 4 über dem kapazitiven Schaltbereich 10 kein Schaltsignal ausgelöst wird. Dazu werden die Dicken und die Materialien der erfindungsgemäßen Verbundscheibe 100 erfindungsgemäß so gewählt, dass der Flächenkapazitätsbelag c_{I} zwischen dem Berührungsbereich 11 und der außenseitigen Oberfläche IV des Substrats 1 größer als der Flächenkapazitätsbelag c_{A} zwischen dem Berührungsbereich 11 und der außenseitigen Oberfläche I der Deckscheibe 4 ist.

Der Flächenkapazitätsbelag c_{I} beziehungsweise c_{A} ist im Rahmen der vorliegenden Erfindung definiert als die Kapazität eines Plattenkondensators desjenigen Bereichs der Verbundscheibe 100, der sich durch orthogonale Projektion des Berührungsbereichs 11 zwischen dem Berührungsbereich 11 und der außenseitigen Oberfläche IV des Substrats 1 beziehungsweise der außenseitigen Oberfläche I der Deckscheibe 4 ergibt, wobei die sich ergebende Kapazität auf die Fläche des Berührungsbereichs normiert wird.

Im in Figur 1B detailliert dargestellten Beispiel ergibt sich der Flächenkapazitätsbelag c_{I} zwischen dem Berührungsbereich 11 und der außenseitigen Oberfläche IV des Substrats 2 als die Serienschaltung der Einzelkapazitätsbeläge (1/c₁+1/c₂)⁻¹, wobei sich der Einzelkapazitätsbelag zu cᵢ=ε₀*ε_{r,i}/dᵢ ergibt. Dies entspricht der Kapazität Cᵢ der jeweiligen Einzellage mit relativer Permittivität ε_{r,i} und Dicke dᵢ, normiert auf die Fläche A des Berührungsbereichs 11, also cᵢ=Cᵢ/A.

Des Weiteren ergibt sich der Flächenkapazitätsbelag c_{I} zwischen dem Berührungsbereich 11 und der außenseitigen Oberfläche I der Deckscheibe 4 als die Serienschaltung der Einzelkapazitätsbeläge (1/c₃+1/c₄+1/c₅)⁻¹.

Die relative Permittivität des Substrats 1 und der Deckscheibe 4 betragen hier beispielsweise ε_{r,1}= ε_{r,4}=7; die relative Permittivität der ersten Zwischenschicht 2 und der zweiten Zwischenschicht 3 betragen hier beispielweise ε_{r,2}= ε_{r,3}=2,6 und die relative Permittivität der Trägerfolie 5 beträgt hier beispielsweise ε_{r,5}=3.

Daraus ergibt sich ein Verhältnis der Flächenkapazitätsbelegungen c_{I}:c_{A} zu 1,2:1.

Des Weiteren ist in diesem Beispiel die Fläche A des Berührungsbereichs 11 und insbesondere dessen Breite b_{B} derart mit der Breite b_{Z} des Zuleitungsbereichs 12 abgestimmt, dass nur bei einer Berührung der außenseitigen Oberfläche IV des Substrats über dem Berührungsbereichs 11 (also in demjenigen Bereich der Oberfläche IV, der sich durch orthogonale Projektion des Berührungsbereichs 11 auf die Oberfläche IV ergibt) ein Schaltsignal ausgibt und nicht bei Berührung der Oberfläche IV über dem Zuleitungsbereich 12.

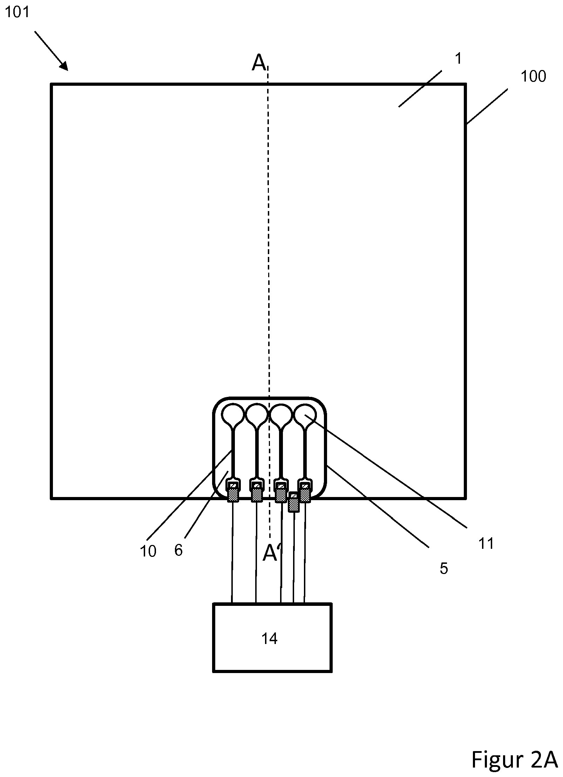

Figur 2A zeigt eine Draufsicht auf eine alternative beispielhafte Ausgestaltung einer erfindungsgemäßen Scheibenanordnung 101 mit einer erfindungsgemäßen Verbundscheibe 100.

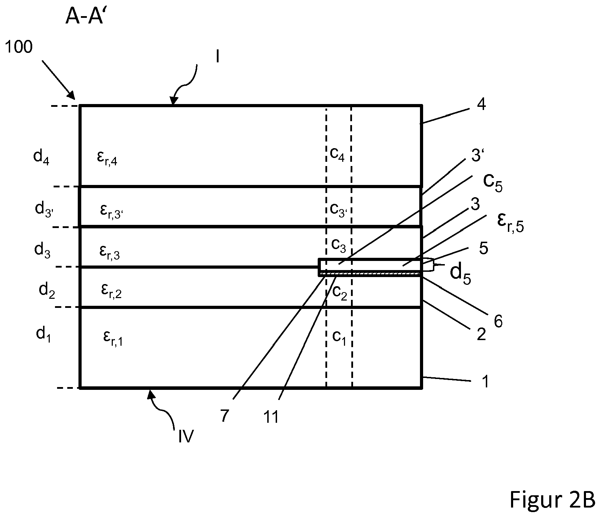

In Figur 2B ist eine Querschnittsdarstellung entlang der Schnittlinie A-A' aus Figur 2A dargestellt. Die Verbundscheibe 100 umfasst hier beispielsweise ein Substrat 1 und eine Deckscheibe 4, die über eine erste Zwischenschicht 2 und eine zweite Zwischenschicht 3 miteinander verbunden sind. Die Verbundscheibe 100 ist beispielsweise eine Fahrzeugscheibe und insbesondere die Dachscheibe eines Personenkraftwagens. Die Abmessungen der Verbundscheibe 100 betragen beispielsweise 1,2 m x 1,2 m. Das Substrat 1 ist beispielsweise dafür vorgesehen, in Einbaulage dem Innenraum zugewandt zu sein. Das heißt, die außenseitige Oberfläche IV des Substrats 1 ist vom Innenraum aus zugänglich, wogegen die außenseitige Oberfläche I der Deckscheibe 4 nach außen weist. Substrat 1 und Deckscheibe 4 bestehen beispielsweise aus Natron-Kalkglas. Die Dicke d₁ des Substrats 1 beträgt beispielsweise 2,1 mm und die Dicke d₄ der Deckscheibe 4 beträgt beispielsweise ebenfalls 2,1 mm. In diesem Ausgestaltungsbeispiel ist die zweite Zwischenschicht 3,3' zweilagig ausgebildet. Die Zwischenschichten 2,3,3' sind thermoplastische Zwischenschichten und bestehen aus Polyvinylbutyral (PVB). Sie weisen jeweils eine Dicke d_{2/3/3'} von 0,38 mm auf. Im mittleren, unteren Abschnitt der Verbundscheibe 100 ist zwischen der ersten Zwischenschicht 2 und der zweiten Zwischenschicht 3 eine Trägerfolie 5 mit einem kapazitiven Schaltbereich 10 angeordnet.

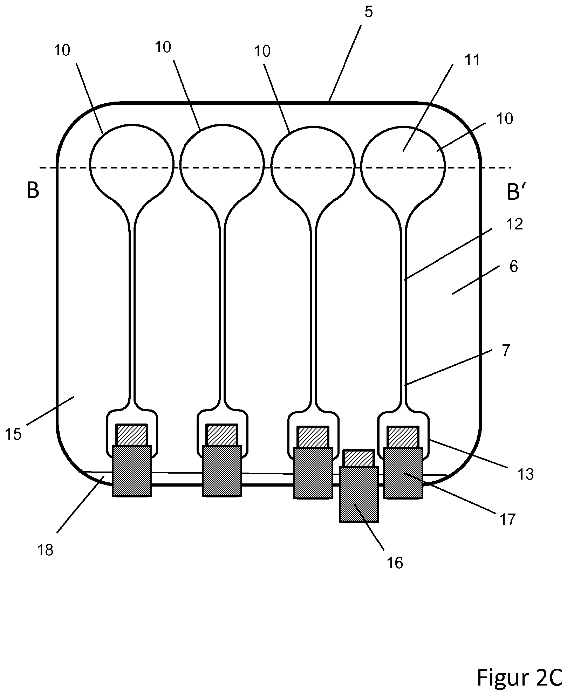

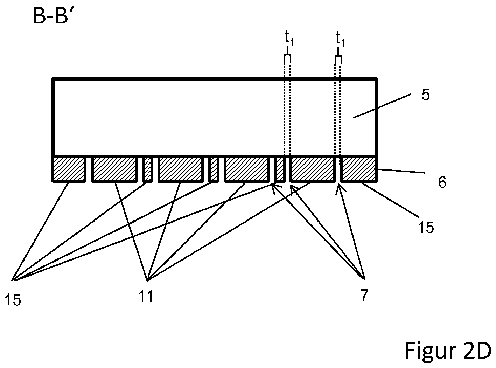

Figur 2C zeigt eine vergrößerte Darstellung der erfindungsgemäßen Trägerfolie 5 aus Figur 2A. Figur 2D zeigt eine dazugehörige Querschnittsdarstellung entlang der Schnittlinie B-B' aus Figur 2C.

Die Trägerfolie 5 ist in diesem Beispiel eine transparente Polyethylenterephthalat (PET)-Folie mit einer Dicke d₅ von 0,05 mm. Die Trägerfolie 5 hat hier eine Länge von beispielsweise 250 mm und eine Breite von beispielsweise 120 mm. Auf der Trägerfolie 5 ist eine transparente, elektrisch leitfähige Schicht 6 angeordnet. Die elektrische leitfähige Schicht 6 ist ein Schichtensystem, welches beispielsweise drei elektrisch leitfähige Silberschichten enthält, die durch dielektrische Schichten voneinander getrennt sind.

Die elektrisch leitfähige Schicht 6 erstreckt sich beispielsweise über die gesamte Oberfläche einer Seite der Trägerfolie 5, abzüglich eines 10 mm breiten beschichtungsfreien Randstreifens 18 der dem äußeren Scheibenrand der Verbundscheibe 100 zugewandt ist. Dieser Bereich wird durch Verkleben der beiden Zwischenschichten 2,3 während des Laminierens hermetisch versiegelt, so dass die elektrisch leitfähige Schicht 6 vor Feuchtigkeit aus der Umgebung der Verbundscheibe 100 und damit vor Korrosion und Beschädigung geschützt ist. Im dargestellten Ausführungsbeispiel ist die elektrisch leitfähige Schicht 6 auf derjenigen Seite der Trägerfolie 5 angeordnet, die dem Substrat 1 zugewandt ist.

Die elektrisch leitfähige Schicht 6 ist durch beschichtungsfreie Trennlinien 7 in unterschiedliche, voneinander elektrisch isolierte Bereiche unterteilt. In dem in Figur 2C dargestellten Beispiel sind vier kapazitive Schaltbereiche 10 von einem gemeinsamen Umgebungsbereich 15 elektrisch unterteilt. Jeder Schaltbereich 10 umfasst einen Berührungsbereich 11, der annähernd tropfenförmig ausgebildet ist und in einen streifenförmigen Zuleitungsbereich 12 übergeht. Die Breite b_{B} und die Länge l_{B} des Berührungsbereichs 11 beträgt jeweils beispielsweise 40 mm. Die Breite b_{Z} des Zuleitungsbereichs 12 beträgt beispielsweise 1 mm. Das Verhältnis von b_{Z}:b_{B} beträgt somit etwa 1:40. Der Zuleitungsbereich 12 ist mit einem Anschlussbereich 13 verbunden. Der Anschlussbereich 13 hat eine quadratische Form mit abgerundeten Ecken und einer Kantenlänge b_{A} von beispielsweise 12 mm. Die Länge l_{Z} des Zuleitungsbereichs beträgt etwa 48 mm.

Die Trennlinie 7 hat lediglich eine Breite t₁ von beispielsweise 100 µm und ist beispielsweise durch Laserstrukturierung in die elektrisch leitfähige Schicht 6 eingebracht. Trennlinien 7 mit einer derart geringen Breite sind optisch kaum wahrnehmbar und stören die Durchsicht durch die Verbundscheibe 100 nur wenig, was besonders für eine Verwendung in Fahrzeugen als Dachscheibe besonders ästhetisch ist.

Der Anschlussbereich 13 ist über eine elektrische Leitungsverbindung 20 mit einem Folienleiter 17 elektrisch leitend verbunden. Eine sichere elektrisch leitende Verbindung wird dabei bevorzugt durch einen elektrisch leitfähigen Kleber erzielt. Der Folienleiter 17 besteht beispielsweise aus einer 50 µm dicken Kupferfolie und ist beispielsweise außerhalb der Anschlussbereichs 13 mit einer Polyimidschicht isoliert. Dadurch kann der Folienleiter 17 ohne elektrischen Kurzschluss über den Umgebungsbereich 15 hinweg über den unteren Rand der Verbundscheibe 100 hinausgeführt werden. Es versteht sich, dass die elektrische Verbindung des Anschlussbereichs 13 nach außen auch über isolierte Drähte oder über einen Bereich, in dem der Umgebungsbereich 15 unterbrochen ist, nach außen geführt werden kann.

Der Folienleiter 17 ist hier beispielsweise außerhalb der Verbundscheibe 100 mit einer kapazitiven Sensorelektronik 14 verbunden. Des Weiteren ist der Umgebungsbereich 15 über einen weiteren Anschlussbereich 16 ebenfalls mit der Sensorelektronik 14 verbunden. Die Sensorelektronik 14 ist dazu geeignet Kapazitätsänderungen des Schaltbereichs 10 gegenüber dem Umgebungsbereich präzise zu messen und in Abhängigkeit eines Schwellwerts ein Schaltsignal beispielsweise an den CAN-Bus eines Fahrzeugs weiter zu geben. Über das Schaltsignal können beliebige Funktionen im Fahrzeug geschaltet werden. Beispielsweise kann die Verbundscheibe 100 eine Suspended Particle Device (SPD), eine elektrochrome oder eine andersartige Schicht oder Folie zur Steuerung der optischen Transparenz aufweisen, die durch das Schaltsignal in ihrer optischen Transparenz verändert werden kann, hier zum Beispiel mit vier Transparenzstufen, die jeweils über die vier kapazitiven Schaltbereiche angewählt werden können. Es versteht sich, dass alternativ oder zusätzlich auch andere elektrische Funktionen wie eine elektrische Beheizung oder eine elektrische Beleuchtung gesteuert werden können.

Wird die Verbundscheibe 100 beispielsweise als Dachscheibe in einem Kraftfahrzeug verwendet, kann die Länge des Zuleitungsbereichs 12 so gewählt werden, dass der Fahrer des Fahrzeugs, der Beifahrer oder Mitfahrer auf den hinteren Sitzplätzen den Berührungsbereich 11 des Schaltbereichs 10 bequem erreichen. Es versteht sich, dass dazu auch mehrere Trägerfolien 5 in der Verbundscheibe 100 angeordnet werden können, beispielsweise jeweils eine Trägerfolie 5 für jeden Fahrzeuginsassen.

Im dargestellten Ausgestaltungsbeispiel ist die Aufbau und die Abstimmung der Sensorelektronik 14 derart abgestimmt, dass bei Berührung der außenseitigen Scheibenoberfläche IV des Substrats 1 über dem Berührungsbereich 11 des kapazitiven Schaltbereichs 10 ein Schaltsignal ausgelöst wird, wobei bei Berührung der außenseitigen Scheibenoberfläche I der Deckscheibe 4 kein Schaltsignal ausgelöst wird. Dies hat den besonderen Vorteil, dass durch beabsichtigte oder versehentliche Berührung der Verbundscheibe 100 von außerhalb des Fahrzeugs kein Schaltsignal ausgelöst werden kann. Außerdem wird die versehentliche Auslösung eine Schaltsignals, beispielsweise durch Regen oder eine Waschanlage, vermieden. Dazu werden die Dicken und die Materialien der erfindungsgemäßen Verbundscheibe 100 erfindungsgemäß so gewählt, dass der Flächenkapazitätsbelag c_{I} zwischen dem Berührungsbereich 11 und der außenseitigen Oberfläche IV des Substrats 1 größer als der Flächenkapazitätsbelag c_{A} zwischen dem Berührungsbereich 11 und der außenseitigen Oberfläche I der Deckscheibe 4 ist.

Im in Figur 2B detailliert dargestellten Beispiel ergibt sich der Flächenkapazitätsbelag c_{I} zwischen dem Berührungsbereich 11 und der außenseitigen Oberfläche IV des Substrats 2 als die Serienschaltung der Einzelkapazitätsbeläge (1/c₁+1/c₂)⁻¹. Des Weiteren ergibt sich der Flächenkapazitätsbelag c_{I} zwischen dem Berührungsbereich 11 und der außenseitigen Oberfläche I der Deckscheibe 4 als die Serienschaltung der Einzelkapazitätsbeläge (1/c₃+1/C_{3'}+1/c₄+1/c₅)⁻¹. Die relative Permittivität des Substrats 1 und der Deckscheibe 4 betragen hier beispielsweise ε_{r,1}= ε_{r,4}=7; die relative Permittivität der ersten Zwischenschicht 2 und der zweiten Zwischenschicht 3,3' betragen hier beispielweise ε_{r,2}=ε_{r,3}= ε_{r,3'}=2,6 und die relative Permittivität der Trägerfolie 5 beträgt hier beispielsweise ε_{r,5}=3. Daraus ergibt sich ein Verhältnis der Flächenkapazitätsbelegungen c_{I}:c_{A} zu 1,4:1.

Des Weiteren ist in diesem Beispiel die Fläche A des Berührungsbereichs 11 und insbesondere dessen Breite b_{B} derart mit der Breite b_{Z} des Zuleitungsbereichs 12 abgestimmt, dass nur bei einer Berührung der außenseitigen Oberfläche IV des Substrats über dem Berührungsbereichs 11 (also in demjenigen Bereich der außenseitigen Oberfläche IV, der sich durch orthogonale Projektion des Berührungsbereichs 11 auf die außenseitige Oberfläche IV ergibt) ein Schaltsignal ausgibt und nicht bei Berührung der außenseitigen Oberfläche IV über dem Zuleitungsbereich 12.

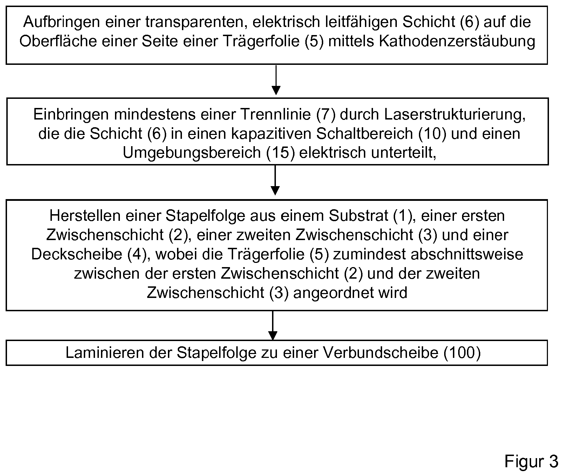

Figur 3 zeigt ein Flussdiagramm eines Ausführungsbeispiels des erfindungsgemäßen Verfahrens zur Herstellung einer Verbundscheibe 100 mit kapazitivem Schaltbereich 10.

Tabelle 1 zeigt die Berechnung der Verhältnisse der Flächenkapazitätsbeläge c_{I}:c_{A} von fünf Ausgestaltungsbeispielen Beispiel 1-5 für verschiedene Materialdicken und Materialparameter. Die Berechnung der Flächenkapazitätsbeläge wurde oben unter Figur 1 und Figur 2 ausführlich dargestellt. Beispiel 3 entspricht dem Ausgestaltungsbeispiel von Figur 1 und Beispiel 1 entspricht dem Ausgestaltungsbeispiel von Figur 2.

**Tabelle 1**

| | **Beispiel 1** | **Beispiel 2** | **Beispiel 3** | **Beispiel 4** | **Beispiel 5** |
|---|---|---|---|---|---|
| | Dicke [mm] | Dicke [mm] | Dicke [mm] | Dicke [mm] | Dicke [mm] |
| **Deckscheibe (4)** Glas, εᵣ=7 | 2,1 | 2,1 | 2,1 | 2,1 | 1,8 |
| **zweite Zwischenschicht (3)** PVB, εᵣ=2,6 | 0,76 | 0,76 | 0,38 | 0,38 | 0,38 |
| **Trägerfolie (5)** PET, εᵣ=3 | 0,05 | 0,05 | 0,05 | 0,05 | 0,05 |
| **erste Zwischenschicht (2)** PVB, εᵣ=2,6 | 0,38 | 0,38 | 0,38 | 0,38 | 0,38 |
| **Substrat (1)** Glas, εᵣ=7 | 2,1 | 1,6 | 1,6 | 1,8 | 1,4 |
| | | | | | |
| **c_{A} in F/m²** | 1,45E-08 | 1,45E-08 | 1,91E-08 | 1,91 E-08 | 2,11 E-08 |
| **c_{I} in F/m²** | 1,98E-08 | 2,36E-08 | 2,36E-08 | 2,20E-08 | 2,56E-08 |
| **c_{I}:c_{A}** | **1,4** | **1,6** | **1,2** | **1,1** | **1,2** |

Erfindungsgemäße Verbundscheiben 100 haben Verhältnisse der Flächenkapazitätsbeläge c_{I}:c_{A} von größer oder gleich 1,1:1. Mit derartigen Verhältnissen konnten eine besonders gute Unterscheidung zwischen einer Berührung der Berührungsfläche 11 über die außenseitige Oberfläche IV des Substrats 1 von gegenüber der außenseitigen Oberfläche I der Deckscheibe 4 erzielt werden.

Die erfindungsgemäße Verbundscheibe 100 nach den Figuren 1 und 2 weist einen kapazitiven Schaltbereich 10 auf, der beispielsweise mit einer kapazitiven Sensorelektronik 14 verbindbar ist. Außerdem ist, durch die geringe Breite der Trennlinien 7, die Sicht durch die Scheibe nur minimal beeinträchtigt und genügt beispielsweise den Anforderungen an eine Fahrzeugverglasung.

Besonders vorteilhaft und überraschend ist eine Scheibenanordnung 101 mit einer Verbundscheibe 100, bei der die Empfindlichkeit der Sensorelektronik 14 derart mit dem Verhältnis der Flächenkapazitätsbeläge c_{I}:c_{A} über dem Berührungsbereiche 11 abgestimmt ist, dass eine selektive Auslösung des Schaltvorgangs nur von einer außenseitigen Oberfläche IV der Verbundscheibe 100 möglich ist.

Dieses Ergebnis war für den Fachmann unerwartet und überraschend.

### Bezugszeichenliste:

- 1: Substrat
- 2: erste Zwischenschicht
- 3,3': zweite Zwischenschicht
- 4: Deckscheibe
- 5: Trägerfolie
- 6: elektrisch leitfähige Schicht
- 7: Trennlinie
- 10: kapazitiver Schaltbereich
- 11: Berührungsbereich
- 12: Zuleitungsbereich
- 13: Anschlussbereich
- 14: kapazitive Sensorelektronik
- 15: Umgebungsbereich
- 16: weiterer Anschlussbereich
- 17: Folienleiter
- 18: beschichtungsfreier Randstreifen
- 20: elektrische Leitungsverbindung
- 100: Verbundscheibe
- 101: Scheibenanordnung

- A: Fläche des Berührungsbereichs 11
- b_{A}: Breite des Anschlussbereichs 13
- b_{B}: Breite des Berührungsbereichs 11
- b_{Z}: Breite des Zuleitungsbereichs 12
- c_{I}, c_{A}, C₁...₅: Flächenkapazitätsbelag
- C₁...₅: Kapazität
- d₁,d₂,d₃,d_{3'},d₄,d₅: Dicke
- ε₀: elektrische Feldkonstante
- ε_{r,1}, ε_{r,2}, ε_{r,3}, ε_{r,3'}, ε_{r,4},: ε_{r,5} relative Permittivität

- l_{A}: Länge des Anschlussbereichs 13
- l_{B}: Länge des Berührungsbereichs 11
- l_{Z}: Länge des Zuleitungsbereichs 12
- t₁: Breite der Trennlinie 7
- A-A': Schnittlinie
- B-B': Schnittlinie
- I: außenseitige Oberfläche der Deckscheibe 4
- IV: außenseitigen Oberfläche des Substrats 1

## Patentansprüche

1. Verbundscheibe (100) mit kapazitivem Schaltbereich (10), umfassend:
- ein Substrat (1),
- mindestens eine erste Zwischenschicht (2), die flächig mit dem Substrat (1) verbunden ist,
- mindestens eine zweite Zwischenschicht (3,3'), die flächig mit der ersten Zwischenschicht (2) verbunden ist, und
- eine Deckscheibe (4), die flächig mit der zweiten Zwischenschicht (3,3') verbunden ist,
wobei
- zwischen der ersten Zwischenschicht (2) und der zweiten Zwischenschicht (3,3') zumindest abschnittsweise eine Trägerfolie (5) mit einer elektrisch leitfähigen Schicht (6) angeordnet ist,
- mindestens ein kapazitiver Schaltbereich (10) durch mindestens eine beschichtungsfreie Trennlinie (7) aus der elektrisch leitfähigen Schicht (6) elektrisch abgetrennt ist,
- der kapazitive Schaltbereich (10) einen Berührungsbereich (11), einen Zuleitungsbereich (12) und einen Anschlussbereich (13) aufweist, der Zuleitungsbereich (12) den Berührungsbereich (11) mit dem Anschlussbereich (13) elektrisch verbindet und der Anschlussbereich (13) mit einer Sensorelektronik (14) elektrisch verbindbar ist, und
- ein Flächenkapazitätsbelag c_{I} zwischen dem Berührungsbereich (11) und der außenseitigen Oberfläche (IV) des Substrats (1), gegeben durch die auf die Fläche des Berührungsbereichs (11) normierte Kapazität eines Plattenkondensators desjenigen Bereichs der Verbundscheibe (100), der sich durch orthogonale Projektion des Berührungsbereichs (11) zwischen dem Berührungsbereich (11) und der außenseitigen Oberfläche (IV) des Substrats (1) ergibt, größer ist als ein Flächenkapazitätsbelag c_{A} zwischen dem Berührungsbereich (11) und der außenseitigen Oberfläche (I) der Deckscheibe (4), gegeben durch die auf die Fläche des Berührungsbereichs (11) normierte Kapazität eines Plattenkondensators desjenigen Bereichs der Verbundscheibe (100), der sich durch orthogonale Projektion des Berührungsbereichs (11) zwischen dem Berührungsbereich (11) und der außenseitigen Oberfläche (I) der Deckscheibe (4) ergibt.

2. Verbundscheibe (100) nach Anspruch 1, wobei das Verhältnis des Flächenkapazitätsbelags c_{I} zum Flächenkapazitätsbelag c_{A} größer oder gleich 1,1:1, bevorzugt größer oder gleich 1,2:1, beträgt.

3. Verbundscheibe (100) nach Anspruch 1 oder Anspruch 2, wobei der Zuleitungsbereich (12) eine Länge l_{Z} von 1 cm bis 70 cm und bevorzugt von 1 cm bis 8 cm aufweist und eine Breite b_{Z} von 0,5 mm bis 10 mm und bevorzugt von 0,5 mm bis 2 mm aufweist und bevorzugt rechteckförmig, streifenförmig oder linienförmig ist.

4. Verbundscheibe (100) nach einem der Ansprüche 1 bis 3, wobei das Verhältnis von Länge l_{Z} zu Breite b_{Z} des Zuleitungsbereichs (12) kleiner oder gleich 1:700 und bevorzugt von 1:5 bis 1:100 beträgt.

5. Verbundscheibe (100) nach einem der Ansprüche 1 bis 4, wobei die Fläche des Berührungsbereichs (11) von 1 cm² bis 200 cm², besonders bevorzugt von 1 cm² bis 9 cm² beträgt und/oder eine rechteckförmige, quadratische, trapezförmige, dreiecksförmige, kreisförmige, elliptische oder tropfenförmige Form oder abgerundete Ecken aufweist.

6. Verbundscheibe (100) nach einem der Ansprüche 1 bis 5, wobei der Bereich der elektrisch leitfähigen Schicht (6) außerhalb des kapazitiven Schaltbereichs (10) einen Umgebungsbereich (15) ausbildet, der über einen weiteren Anschlussbereich (16) mit der Sensorelektronik (14) verbindbar ist.

7. Verbundscheibe (100) nach einem der Ansprüche 1 bis 6, wobei die Breite t₁ der Trennlinie (7) von 30 µm bis 200 µm und bevorzugt von 70 µm bis 140 µm beträgt.

8. Verbundscheibe (100) nach einem der Ansprüche 1 bis 7, wobei die erste Zwischenschicht (2) und/oder die zweite Zwischenschicht (3,3') transparent ist, Polyvinylbutyral (PVB) enthält oder daraus besteht, und/oder eine relative Permittivität ε_{r,2/3/3'} von 2 bis 4 und besonders bevorzugt von 2,1 bis 2,9 aufweist.

9. Verbundscheibe (100) nach einem der Ansprüche 1 bis 8, wobei die Trägerfolie (5) transparent ist, Polyethylenterephthalat (PET) enthält oder daraus besteht, und/oder eine relative Permittivität ε_{r,5} von 2 bis 4 und besonders bevorzugt von 2,7 bis 3,3 aufweist.

10. Verbundscheibe (100) nach einem der Ansprüche 1 bis 9, wobei das Substrat (1) und/oder die Deckscheibe (4) Glas, bevorzugt Flachglas, Floatglas, Quarzglas, Borosilikatglas, Kalk-Natron-Glas, oder Polymere, bevorzugt Polyethylen, Polypropylen, Polycarbonat, Polymethylmethacrylat und/oder Gemische davon enthält, und/oder eine relative Permittivität ε_{r,1/4} von 2 bis 8 und besonders bevorzugt von 6 bis 8 aufweist.

11. Verbundscheibe (100) nach einem der Ansprüche 1 bis 10, wobei die elektrisch leitfähige Schicht (2) transparent ist und/oder einen Flächenwiderstand von 0,4 Ohm/Quadrat bis 200 Ohm/Quadrat und bevorzugt von 0,5 Ohm/Quadrat bis 20 Ohm/Quadrat aufweist und/oder Silber (Ag), Indium-Zinnoxid (ITO), fluordotiertes Zinnoxid (SnO₂:F) oder aluminiumdotiertes Zinkoxid (ZnO:Al) enthält.

12. Scheibenanordnung (101) umfassend:
- eine Verbundscheibe (100) nach einem der Ansprüche 1 bis 11 und
- eine kapazitive Sensorelektronik (14), die mit dem Anschlussbereich (13) elektrisch verbunden ist,
wobei die Empfindlichkeit der Sensorelektronik (14) so gewählt ist, dass sie bei Berührung des Berührungsbereichs (11) mit einem menschlichen Finger auf der Oberfläche (IV) des Substrats (1) ein Schaltsignal ausgibt und bei Berührung des Berührungsbereichs (11) auf der Oberfläche (I) der Deckscheibe (4) kein Schalt-signal oder ein anderes Schaltsignal ausgibt.

13. Scheibenanordnung (101) umfassend:
- eine Verbundscheibe (100) nach einem der Ansprüche 1 bis 11 und
- eine kapazitive Sensorelektronik (14), die mit dem Anschlussbereich (13) elektrisch verbunden ist,
wobei die Empfindlichkeit der Sensorelektronik (14) so gewählt ist, dass sie bei Berührung des Berührungsbereichs (11) auf der Oberfläche (IV) des Substrats (1) und/oder der Oberfläche (I) der Deckscheibe (4) mit einem menschlichen Finger ein Schaltsignal ausgibt und bei Berührung des Zuleitungsbereichs (12) auf der Oberfläche (IV) des Substrats (1) und/oder der Oberfläche (I) der Deckscheibe (4) kein Schaltsignal oder ein anderes Schaltsignal ausgibt.

14. Verfahren zur Herstellung einer Verbundscheibe (100) nach einem der Ansprüche 1 bis 11, mindestens umfassend:
(a) Aufbringen einer elektrisch leitfähigen Schicht (6) auf einer Oberfläche einer Trägerfolie (5),
(b) Einbringen mindestens einer Trennlinie (7), die die Schicht (6) in mindestens einen kapazitiven Schaltbereich (10) und mindestens einen Umgebungsbereich (15) elektrisch unterteilt, bevorzugt durch Laserstrukturierung oder durch mechanisches oder chemisches Abtragen, und
(c) Herstellen einer Stapelfolge aus einem Substrat (1), einer ersten Zwischenschicht (2), einer zweiten Zwischenschicht (3) und einer Deckscheibe (4), wobei die Trägerfolie (5) zumindest abschnittsweise zwischen der ersten Zwischenschicht (2) und der zweiten Zwischenschicht (3) angeordnet wird und
(d) Laminieren der Stapelfolge zu einer Verbundscheibe (100).

15. Verwendung der Verbundscheibe (100) nach einen der Ansprüche 1 bis 11 in Fortbewegungsmitteln für den Verkehr auf dem Lande, in der Luft oder zu Wasser, insbesondere in Kraftfahrzeugen beispielsweise als Windschutzscheibe, Heckscheibe, Seitenscheiben und/oder Dachscheibe sowie als funktionales Einzelstück, und als Einbauteil in Möbeln, Geräten und Gebäuden, insbesondere als elektrischer Heizkörper.

## Claims

1. Composite pane (100) with a capacitive switching zone (10), comprising:
- a substrate (1),
- at least one first intermediate layer (2), which is areally bonded to the substrate (1),
- at least one second intermediate layer (3,3'), which is areally bonded to the first intermediate layer (2), and
- a cover pane (4), which is areally bonded to the second intermediate layer (3,3'),
wherein
- a carrier film (5) with an electrically conductive layer (6) is arranged, at least in sections, between the first intermediate layer (2) and the second intermediate layer (3,3'),
- at least one capacitive switching zone (10) is electrically separated from the electrically conductive layer (6) by at least one coating-free separating line (7),
- the capacitive switching zone (10) has a contact zone (11), a supply line zone (12), and a connection zone (13), with the supply line zone (12) electrically connecting the contact zone (11) to the connection zone (13), and the connection zone (13) being electrically connectable to sensor electronics (14), and
- a surface capacitance c_{I} between the contact zone (11) and the outside surface (IV) of the substrate (1), as defined as the capacitance of a plate capacitor of that zone of the composite pane (100) that results from orthogonal projection of the contact zone (11) between the contact zone (11) and the outside surface (IV) of the substrate (1), with the resultant capacitance normalized to the area of the contact zone (11), is greater than a surface capacitance c_{A} between the contact zone (11) and the outside surface (I) of the cover pane (4), as defined as the capacitance of a plate capacitor of that zone of the composite pane (100) that results from orthogonal projection of the contact zone (11) between the contact zone (11) and the outside surface (I) of the cover pane (4), with the resultant capacitance normalized to the area of the contact zone (11).

2. Composite pane (100) according to claim 1, wherein the ratio of the surface capacitance c_{I} to the surface capacitance c_{A} is greater than or equal to 1.1:1, preferably greater than or equal to 1.2:1.

3. Composite pane (100) according to claim 1 or claim 2, wherein the supply line zone (12) has a length l_{Z} of 1 cm to 70 cm and preferably of 1 cm to 8 cm and has a width bz of 0.5 mm to 10 mm and preferably of 0.5 mm to 2 mm and preferably has the shape of a rectangle, a strip, or a line.

4. Composite pane (100) according to one of claims 1 through 3, wherein the ratio of length l_{Z} to width bz of the supply line zone (12) is less than or equal to 1:700 and preferably from 1:5 to 1:100.

5. Composite pane (100) according to one of claims 1 through 4, wherein the area of the contact zone (11) is from 1 cm² to 200 cm², particularly preferably from 1 cm² to 9 cm² and/or has the shape of a rectangle, square, trapezoid, triangle, circle, ellipse, or drop or has rounded corners.

6. Composite pane (100) according to one of claims 1 through 5, wherein the region of the electrically conductive layer (6) outside the capacitive switching zone (10) forms a surrounding zone (15), which is connectable to the sensor electronics (14) via another connection zone (16).

7. Composite pane (100) according to one of claims 1 through 6, wherein the width t₁ of the separating line (7) is from 30 µm to 200 µm and preferably from 70 µm to 140 µm.

8. Composite pane (100) according to one of claims 1 through 7, wherein the first intermediate layer (2) and/or the second intermediate layer (3,3') is transparent, contains or is made of polyvinyl butyral (PVB), and/or has a relative permittivity εᵣ,_{2/3/3'} of 2 to 4 and particularly preferably of 2.1 to 2.9.

9. Composite pane (100) according to one of claims 1 through 8, wherein the carrier film (5) is transparent, contains or is made of polyethylene terephthalate (PET), and/or has a relative permittivity ε_{r,5} of 2 to 4 and particularly preferably of 2.7 to 3.3.

10. Composite pane (100) according to one of claims 1 through 9, wherein the substrate (1) and/or the cover pane (4) contains glass, preferably flat glass, float glass, quartz glass, borosilicate glass, soda lime glass, or polymers, preferably polyethylene, polypropylene, polycarbonate, polymethyl methacrylate, and/or mixtures thereof, and/or has a relative permittivity ε_{r,1/4} of 2 to 8 and particularly preferably of 6 to 8.

11. Composite pane (100) according to one of claims 1 through 10, wherein the electrically conductive layer (2) is transparent and/or has a sheet resistance of 0.4 ohm/square to 200 ohm/square and preferably of 0.5 ohm/square to 20 ohm/square and/or contains silver(Ag), indium tin oxide (ITO), fluorine-doped tin oxide (SnO₂:F), or aluminum-doped zinc oxide (ZnO:AI).

12. Pane arrangement (101) comprising:
- a composite pane (100) according to one of claims 1 through 11 and
- capacitive sensor electronics (14), which are electrically connected to the connection zone (13),
wherein the sensitivity of the sensor electronics (14) is selected such that a switching signal is issued when the contact zone (11) on the surface (IV) of the substrate (1) is touched by a human finger and no switching signal or a different switching signal is issued when the contact zone (11) on the surface (I) of the cover pane (4) is touched.

13. Pane arrangement (101) comprising:
- a composite pane (100) according to one of claims 1 through 11 and
- capacitive sensor electronics (14), which are electrically connected to the connection zone (13),
wherein the sensitivity of the sensor electronics (14) is selected such that a switching signal is issued when the contact zone (11) on the surface (IV) of the substrate (1) and/or the surface (I) of the cover pane (4) is touched by a human finger and no switching signal or a different switching signal is issued when the supply line zone (12) on the surface (IV) of the substrate (1) and/or the surface (I) of the cover pane (4) is touched.

14. Method for producing a composite pane (100) according to one of claims 1 through 11, comprising at least:
(a) Application of an electrically conductive layer (6) on a surface of a carrier film (5),
(b) Introduction of at least one separating line (7), which electrically divides the layer (6) into at least one capacitive switching zone (10) and at least one surrounding zone (15), preferably by laser patterning or by mechanical or chemical ablation, and
(c) Production of a stack sequence consisting of a substrate (1), a first intermediate layer (2), a second intermediate layer (3), and a cover pane (4), wherein the carrier film (5) is arranged, at least in sections, between the first intermediate layer (2) and the second intermediate layer (3), and
(d) Lamination of the stack sequence to form a composite pane (100).

15. Use of the composite pane (100) according to one of claims 1 through 11 in means of transportation for travel on land, in the air, or on water, in particular in motor vehicles, for example, as a windshield, rear window, side windows, and/or roof panel as well as a functional individual piece, and as a built-in component in furniture, devices, and buildings, in particular as an electric heater.

## Revendications

1. Vitre composite (100) avec une zone de commutation capacitive (10), comprenant:
- un substrat (1),
- au moins une première couche intermédiaire (2), qui est liée de manière plane au substrat (1),
- au moins une deuxième couche intermédiaire (3, 3'), qui est liée de manière plane à la première couche intermédiaire (2), et
- une vitre de couverture (4), qui est liée de manière plane à la deuxième couche intermédiaire (3, 3'),
dans lequel
- un film porteur (5) avec une couche électriquement conductrice (6) est disposé, au moins par sections, entre la première couche intermédiaire (2) et la deuxième couche intermédiaire (3, 3'),
- au moins une zone de commutation capacitive (10) est séparée électriquement de la couche électriquement conductrice (6) par au moins une ligne de séparation sans revêtement (7),
- la zone de commutation capacitive (10) présente une zone de contact (11), une zone de ligne d'alimentation (12) et une zone de connexion (13), la zone de ligne d'alimentation (12) reliant électriquement la zone de contact (11) à la zone de connexion (13), et la zone de connexion (13) pouvant être reliée électriquement à une électronique de capteur (14), et
- une capacité de surface c_{I} entre la zone de contact (11) et la surface extérieure (IV) du substrat (1), telle que définie comme la capacité d'un condensateur à plaques de cette zone du vitre composite (100) qui résulte d'une projection orthogonale de la zone de contact (11) entre la zone de contact (11) et la surface extérieure (IV) du substrat (1), la capacité résultante étant normalisée par rapport à la surface de la zone de contact (11), est supérieure à une capacité de surface c_{A} entre la zone de contact (11) et la surface extérieure (I) de la vitre de couverture (4), telle que définie comme la capacité d'un condensateur à plaques de cette zone de la vitre composite (100) qui résulte d'une projection orthogonale de la zone de contact (11) entre la zone de contact (11) et la surface extérieure (I) de la vitre de couverture (4), la capacité résultante étant normalisée par rapport à la surface de la zone de contact (11).

2. Vitre composite (100) selon la revendication 1, dans laquelle le rapport de la capacité de surface c_{I} sur la capacité de surface c_{A} est supérieur ou égal à 1,1:1, de préférence supérieur ou égal à 1,2:1.

3. Vitre composite (100) selon la revendication 1 ou la revendication 2, dans laquelle la zone de ligne d'alimentation (12) a une longueur l_{Z} de 1 cm à 70 cm et de préférence de 1 cm à 8 cm et a une largeur bz de 0,5 mm à 10 mm et de préférence de 0,5 mm à 2 mm et a de préférence la forme d'un rectangle, d'une bande ou d'une ligne.

4. Vitre composite (100) selon l'une des revendications 1 à 3, dans laquelle le rapport entre la longueur l_{Z} et la largeur bz de la zone de ligne d'alimentation (12) est inférieur ou égal à 1:700 et de préférence de 1:5 à 1:100.

5. Vitre composite (100) selon l'une des revendications 1 à 4, dans laquelle la surface de la zone de contact (11) est comprise entre 1 cm² et 200 cm², de manière particulièrement préférée entre 1 cm² et 9 cm² et/ou a la forme d'un rectangle, d'un carré, d'un trapèze, d'un triangle, d'un cercle, d'une ellipse, d'une goutte ou présente des coins arrondis.

6. Vitre composite (100) selon l'une des revendications 1 à 5, dans laquelle la région de la couche électriquement conductrice (6) située à l'extérieur de la zone de commutation capacitive (10) forme une zone périphérique (15), qui peut être reliée à l'électronique du capteur (14) par une autre zone de connexion (16).

7. Vitre composite (100) selon l'une des revendications 1 à 6, dans laquelle la largeur t₁ de la ligne de séparation (7) est comprise entre 30 µm et 200 µm et de préférence entre 70 µm et 140 µm.

8. Vitre composite (100) selon l'une des revendications 1 à 7, dans laquelle la première couche intermédiaire (2) et/ou la deuxième couche intermédiaire (3, 3') est transparente, contient ou est constituée de polyvinylbutyral (PVB), et/ou présente une permittivité relative ε_{r,2/3/3'} de 2 à 4 et de manière particulièrement préférée de 2,1 à 2,9.

9. Vitre composite (100) selon l'une des revendications 1 à 8, dans laquelle le film porteur (5) est transparent, contient ou est constitué de polyéthylène téréphtalate (PET), et/ou présente une permittivité relative ε_{r,5} de 2 à 4 et de manière particulièrement préférée de 2,7 à 3,3.

10. Vitre composite (100) selon l'une des revendications 1 à 9, dans laquelle le substrat (1) et/ou la vitre de couverture (4) contient du verre, de préférence du verre plat, du verre flotté, du verre de quartz, du verre borosilicaté, du verre sodocalcique, ou des polymères, de préférence du polyéthylène, du polypropylène, du polycarbonate, du polyméthacrylate de méthyle, et/ou des mélanges de ceux-ci, et/ou présente une permittivité relative ε_{r,1/4} de 2 à 8 et de manière particulièrement préférée de 6 à 8.

11. Vitre composite (100) selon l'une des revendications 1 à 10, dans laquelle la couche électriquement conductrice (2) est transparente et/ou présente une résistance de feuille de 0,4 ohm/carré à 200 ohm/carré et de préférence de 0,5 ohm/carré à 20 ohm/carré et/ou contient de l'argent (Ag), de l'oxyde d'indium-étain (ITO), de l'oxyde d'étain dopé au fluor (Sn02:F) ou de l'oxyde de zinc dopé à l'aluminium (ZnO:Al).

12. Agencement de vitrage (101) comprenant :
- une vitre composite (100) selon l'une des revendications 1 à 11 et
- une électronique de détection capacitive (14), qui est reliée électriquement à la zone de connexion (13),
dans lequel la sensibilité de l'électronique de détection (14) est choisie de telle sorte qu'un signal de commutation est émis lorsque la zone de contact (11) sur la surface (IV) du substrat (1) est touchée par un doigt humain et qu'aucun signal de commutation ou un signal de commutation différent est émis lorsque la zone de contact (11) sur la surface (I) de la vitre de recouvrement (4) est touchée.

13. Agencement de vitre (101) comprenant :
- une vitre composite (100) selon l'une des revendications 1 à 11 et
- une électronique de détection capacitive (14), qui est reliée électriquement à la zone de connexion (13),
dans lequel la sensibilité de l'électronique de détection (14) est choisie de telle sorte qu'un signal de commutation est émis lorsque la zone de contact (11) sur la surface (IV) du substrat (1) et/ou la surface (I) de la vitre de recouvrement (4) est touchée par un doigt humain et qu'aucun signal de commutation ou un signal de commutation différent est émis lorsque la zone de ligne d'alimentation (12) sur la surface (IV) du substrat (1) et/ou la surface (I) de la vitre de recouvrement (4) est touchée.

14. Procédé de fabrication d'une vitre composite (100) selon l'une des revendications 1 à 11, comprenant au moins :
(a) Application d'une couche électriquement conductrice (6) sur une surface d'un film porteur (5),
(b) Introduction d'au moins une ligne de séparation (7) qui divise électriquement la couche (6) en au moins une zone de commutation capacitive (10) et au moins une zone périphérique (15), de préférence par structuration au laser ou par ablation mécanique ou chimique, et
(c) Fabrication d'une séquence d'empilement constituée d'un substrat (1), d'une première couche intermédiaire (2), d'une deuxième couche intermédiaire (3) et d'une vitre de couverture (4), le film porteur (5) étant disposé, au moins par sections, entre la première couche intermédiaire (2) et la deuxième couche intermédiaire (3), et
(d) Stratification de la séquence d'empilement pour former une vitre composite (100).

15. Utilisation de la vitre composite (100) selon l'une des revendications 1 à 11 dans des moyens de transport pour des déplacements sur terre, dans l'air ou sur l'eau, en particulier dans des véhicules automobiles, par exemple comme pare-brise, lunette arrière, vitres latérales et/ou panneau de toit ainsi que comme pièce individuelle fonctionnelle, et comme composant intégré dans des meubles, appareils et bâtiments, en particulier comme chauffage électrique.
